# DEMANDE DE BREVET EUROPEEN

(11) **EP 2 509 110 A1**
(43) Date de publication de la demande: **10.10.2012**
(21) Numéro de dépôt: 12354025.4
(22) Date de dépôt: 30.03.2012
(51) Int. Cl.: H01L 29/786, H01L 21/762

(54) **Transistor à effet de champ avec prise de contre-électrode décalée**

(30) Priorité: 04.04.2011 FR 1101004
(71) Demandeur: Commissariat à l'Énergie Atomique et aux Énergies Alternatives, 75015 Paris (FR)
(72) Inventeur: Vinet, Maud, 38140 Rives (FR); Grenouillet, Laurent, 38140 Rives (FR); Le Tiec, Yannick, 38920 Crolles (FR); Posseme, Nicolas, 29660 Carantec (FR)
(74) Mandataire: Talbot, Alexandre

(57) **Abrégé**

Le transistor à effet de champ comporte un substrat comprenant successivement un substrat de support (1) électriquement conducteur, une couche électriquement isolante (2) et une couche en matériau semi-conducteur (3). La contre-électrode (4) est formée dans une première portion (9) du substrat de support (1) face à la couche en matériau semi-conducteur (3). Le motif d'isolation (5) entoure la couche en matériau semi-conducteur (3) pour délimiter une première zone active (7) et il s'enfonce partiellement dans la couche de support (1) pour délimiter la première portion (9). Un contact (14) électriquement conducteur traverse le motif d'isolation (5) depuis une première face latérale en contact avec la contre-électrode (4) jusqu'à une seconde face. Le contact est connecté électriquement à la contre-électrode (4).

## Description

### Domaine technique de l'invention

L'invention est relative à un dispositif à effet de champ intégré sur un substrat de type semi-conducteur sur isolant et possédant une contre-électrode.

L'invention est également relative à un procédé de fabrication d'un tel dispositif.

### État de la technique

Avec la réduction continue de leurs dimensions, les dispositifs actifs des circuits intégrés, comme les transistors conventionnels, présentent des effets de plus en plus marqués parasites sur leurs caractéristiques électriques, par exemple l'effet canal court. Afin de remédier à un certain nombre de ces écueils, différentes solutions sont envisagées.

Les substrats sur lesquels les transistors sont intégrés ont été modifiés afin de réduire certains des phénomènes parasites des transistors. Ces substrats améliorés sont de type semi-conducteur sur isolant. Ils sont formés par une couche en matériau semi-conducteur séparée du substrat de support par un matériau diélectrique. Selon l'épaisseur de la couche en matériau semi-conducteur sur laquelle est intégré le transistor à effet de champ, le substrat est dit partiellement ou complètement déplété.

En utilisant successivement les substrats de type semi-conducteur sur isolant partiellement déplété puis complètement déplété, il a été possible de poursuivre la course à la miniaturisation et au perfectionnement continu des transistors.

Les substrats de type semi-conducteur sur isolant complètement déplété ont ensuite été modifiés en diminuant l'épaisseur de la couche en matériau diélectrique et en intégrant une couche dopée dans le substrat de support. Cette couche dopée est réalisée à proximité de la couche diélectrique afin de former un plan de masse. Ce plan de masse permet une meilleure maîtrise des effets parasites du transistor intégré sur la couche en matériau semi-conducteur, notamment l'effet canal court au moyen d'une meilleure commande de l'abaissement de la barrière induite par l'électrode de drain (DIBL). Utiliser un plan de masse permet également de modifier facilement les caractéristiques électriques du transistor, typiquement en faisant évoluer sa tension de seuil.

Le plan de masse représente une nouvelle électrode du transistor également appelé contre-électrode. Cette nouvelle électrode doit être associée à un potentiel ce qui nécessite l'intégration d'un contact supplémentaire. Cette nouvelle contrainte entraîne l'intégration d'étapes technologiques supplémentaires. Le dispositif est donc plus difficile à fabriquer et également plus difficile à intégrer dans les circuits car il occupe une plus grande surface et un plus grand volume de matière.

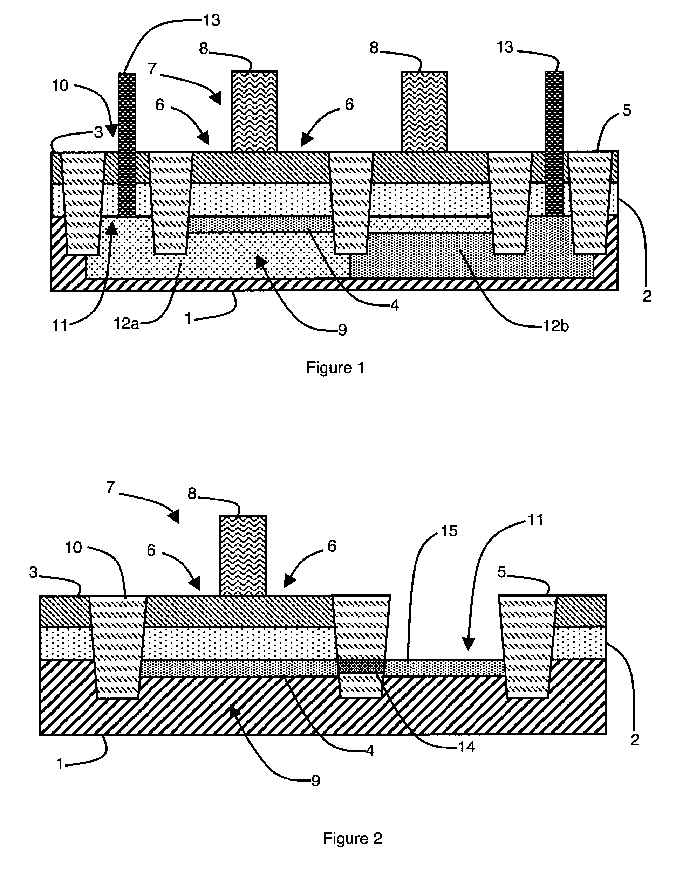

Comme cela est illustré à la figure 1, un premier transistor est réalisé sur un substrat de type semi-conducteur sur isolant qui comporte un substrat de support 1, une couche électriquement isolante 2 et une couche en matériau semi-conducteur 3. Le substrat de support 1 est en silicium et il est dopé pour former la contre-électrode 4. Un motif d'isolation 5 est formé autour du transistor afin d'isoler les électrodes 6 de source/drain du reste de la couche 3 en matériau semi-conducteur.

Le motif d'isolation 5 définit une première zone active 7 dans la couche 3 en matériau semi-conducteur. Cette première zone active 7 contient les électrodes 6 de source/drain du transistor et le canal de conduction. L'électrode de grille 8 du transistor est disposée entre les électrodes 6 de source/drain, au-dessus du canal de conduction. Le motif d'isolation 5 s'enfonce jusque dans le substrat de support 1 pour définir une première portion 9 dans le substrat de support 1 et isoler latéralement la contre-électrode 4 du reste du substrat de support 1.

Le motif d'isolation 5 définit une seconde zone active 10 dans la couche en matériau semi-conducteur et une seconde portion 11 dans le substrat de support. Cette seconde portion 11 est reliée électriquement à la première portion 7 au moyen d'une seconde zone dopée 12 du type de conductivité opposé à celui de la contre-électrode 4. Ainsi, le potentiel appliqué dans la seconde portion 11 au moyen du plot 13 est également appliqué à la contre-électrode 4 par l'intermédiaire de la zone dopée 12.

Un second transistor de type opposé peut être intégré à côté du premier transistor. Les architectures sont similaires, mais les types de dopage sont opposés, notamment les zones 12a et 12b en contact.

Il apparaît que cette structure est difficile à mettre en oeuvre et qu'elle occupe un volume important du substrat de support 1. Elle engendre des limitations importantes dans les conditions de polarisation car l'isolation entre les différentes zones dopées 12 est réalisée au moyen de jonctions PN polarisées pour être à l'état bloqué. Ces limitations sont d'autant plus importantes que des transistors de types opposés sont disposés adjacents.

### Objet de l'invention

On constate qu'il existe un besoin de prévoir un transistor à effet de champ muni d'une contre-électrode qui présente un encombrement réduit.

On tend à assouvir ce besoin au moyen d'un dispositif qui comporte :
- un substrat comprenant successivement un substrat de support électriquement conducteur, une couche électriquement isolante et une couche en matériau semi-conducteur,
- une contre-électrode formée dans une première portion du substrat de support face à la couche en matériau semi-conducteur,
- un motif d'isolation en matériau électriquement isolant entourant la couche en matériau semi-conducteur pour délimiter une première zone active en matériau semi-conducteur et s'enfonçant partiellement dans la couche de support pour délimiter la première portion,
- un contact électriquement conducteur traversant le motif d'isolation depuis une première face latérale en contact avec la contre-électrode jusqu'à une seconde face, le contact étant connecté électriquement à la contre-électrode.

On constate qu'il existe un besoin de prévoir un procédé de fabrication d'un tel dispositif de manière simple.

On tend à assouvir ce besoin au moyen d'un procédé qui comporte :
- prévoir un substrat comportant successivement une couche de support, une couche électriquement isolante, une couche en matériau semi-conducteur, un motif d'isolation délimitant une première zone active dans la couche en matériau semi-conducteur et une première portion dans la couche de support, la première zone active et la première portion se faisant face,
- graver partiellement le motif d'isolation pour accéder à la première portion de la couche de support,
- déposer un film électriquement conducteur en contact de la première portion de la couche de support, sur le motif d'isolation.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, de manière schématique, en coupe, un transistor à effet de champ muni d'une contre-électrode et d'un contact déporté,
- la figure 2 représente, de manière schématique, en coupe, un autre mode de réalisation d'un transistor à effet de champ muni d'une contre-électrode et d'un contact déporté,
- la figure 3 représente, de manière schématique, en vue de dessus, le transistor à effet de champ muni d'une contre-électrode et d'un contact déporté illustré à la figure 2,
- la figure 4 représente, de manière schématique, en coupe, deux transistors à effet de champ munis chacun d'une contre-électrode et d'un contact déporté,
- les figures 5 à 12 représentent, de manière schématique en coupe ou en vue de dessus des étapes d'un mode de mise en oeuvre de transistors à effet de champ muni d'un contact de contre-électrode déporté,
- les figures 13 à 14 représentent, de manière schématique, en coupe, des variantes de réalisation des contacts déportés.

### Description de modes de réalisation préférentiels de l'invention

Comme cela est illustré à la figure 2, un substrat de type semi-conducteur sur isolant comporte successivement un substrat de support 1, une couche électriquement isolante 2 et un film en matériau semi-conducteur 3. Le film en matériau semi-conducteur 3 est une couche dite active car elle est destinée à intégrer un ou plusieurs transistors à effet de champ ou d'autres dispositifs.

Le substrat de support 1 comporte un film en matériau électriquement conducteur qui est en contact avec la couche électriquement isolante 2. De cette manière, le film en matériau électriquement conducteur du substrat de support 1 est séparé du film 3, par la couche électriquement isolante 2.

Selon les modes de réalisation, le substrat 1 peut être formé par un seul et même matériau semi-conducteur ou par une pluralité de films différents conducteurs électriquement. De manière préférentielle, le substrat de support 1 est formé par un matériau semi-conducteur, par exemple du silicium, ce qui permet de conserver un coût de fabrication maîtrisé.

Le film électriquement conducteur du substrat de support 1 peut être un métal, un matériau à base de métal, ou un matériau semi-conducteur dopé. Le film électriquement conducteur est en contact avec la couche électriquement isolante 2 ce qui permet d'avoir un effet électrostatique important sur le canal de conduction.

Le film en matériau électriquement conducteur est dans un matériau apte à former une contre-électrode 4, par exemple un matériau semi-conducteur qui est dopé ou qui peut être dopé ou un métal.

Comme cela est illustré à la figure 2, un motif d'isolation 5 est formé. Le motif d'isolation 5 définit une première zone active 7 dans le film 3 semi-conducteur. Le motif d'isolation 5 définit également une première portion 9 du substrat de support 1. La première portion 9 et la première zone active 7 sont délimitées par le motif d'isolation 5. De cette manière, le motif d'isolation 5 fait le tour de la première portion 9 et le tour de la première zone active 7. La première portion 9 est disposée en face de la première zone active 7. La première portion 9 comporte la contre-électrode 4 qui est destinée à être associée au transistor qui sera formé sur la première zone active 7.

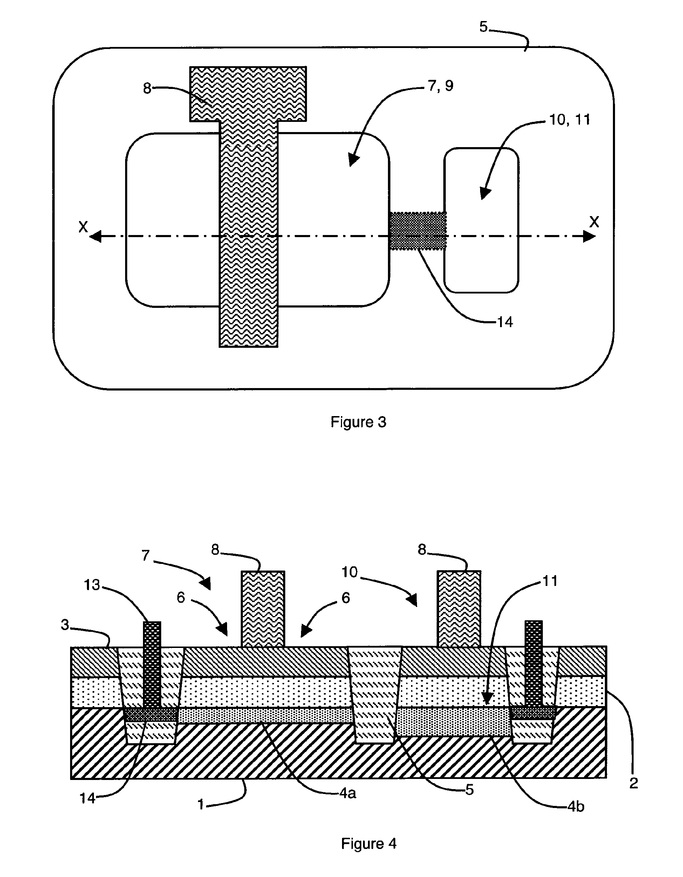

Comme cela est illustré aux figures 2 et 3, le motif d'isolation 5 peut définir une pluralité de zones actives dans le film 3 semi-conducteur et une pluralité de portions dans le substrat de support 1. Le dessin du motif d'isolation 5 est complémentaire du dessin des portions du substrat de support 1 et du dessin des zones actives.

Le motif d'isolation 5 peut être perçu comme un motif en matériau électriquement isolant de forme annulaire. Dans ce cas, un ou plusieurs empilements de couches du substrat se trouvent à l'intérieur de l'anneau. Pour éviter les courts-circuits, les différentes zones actives sont séparées, latéralement, les unes des autres par le motif d'isolation 5. Les différentes portions du substrat de support 1 sont également séparées latéralement les unes des autres par le motif d'isolation 5 pour éviter les courts-circuits.

En d'autres termes, le motif d'isolation 5 permet d'isoler électriquement le futur transistor d'autres composants adjacents. Le motif d'isolation 5 permet également d'isoler latéralement la future contre-électrode 4 du reste du substrat 1, par exemple d'autres contre-électrodes. Dans un mode de réalisation préférentiel, l'isolation verticale dans le substrat peut être réalisée au moyen de jonctions de type P/N ou P/N ou encore au moyen de jonctions P+/P ou N+/N. Les caissons dopés servant à la formation des jonctions sont préférentiellement moins profonds que le motif d'isolation 5.

Le transistor comporte un contact 14 électriquement conducteur qui traverse le motif d'isolation 5 depuis une première face latérale qui est en contact avec la contre-électrode 4 jusqu'à une seconde face. Ce contact 14 traversant permet de polariser la contre-électrode 4 sans passer à travers la zone active 7 ce qui évite de sacrifier une partie du volume dédié aux électrodes 6 de source/drain ou au canal. Cette configuration évite également de passer sous le motif d'isolation 5 ce qui limite le volume occupé par la contre-électrode. Cette approche permet, par exemple, d'intégrer des transistors à contre-électrode avec une forte densité sans nécessairement utiliser des moyens d'isolation additionnels comme des diodes PN polarisées en inverse. L'isolation est réalisée par le motif d'isolation 5.

Dans l'exemple illustré à la figure 3, le contact 14 est une simple bande conductrice qui traverse le motif d'isolation 5 depuis une première face latérale jusqu'à une seconde face latérale opposée de manière à faciliter la polarisation depuis une zone découverte du motif d'isolation 5, par exemple une seconde zone active 10 ou une seconde portion 11 du substrat de support 1. La figure 2 est en vue en coupe du transistor illustré à la figure 3 selon l'axe XX. Le contact 14 relie électriquement la première portion 9 à la seconde portion 11 et il est enrobé sur ses autres faces par le motif d'isolation 5. La forme du contact 14 est quelconque. De manière préférentielle la première portion 9 comporte une zone conductrice 15, par exemple une zone dopée du support 1, un siliciure ou un métal, en contact avec le contact 14 pour polariser la contre-électrode 4.

Cependant, dans un autre mode de réalisation illustré à la figure 4, le contact 14 peut déboucher sur une face principale du motif d'isolation 5, par exemple, la face supérieure du motif 5 qui est parallèle à la face principale du film 3 en matériau semi-conducteur. Dans un cas particulier, la face supérieure du motif 5 et la face principale du film 3 sont dans un même plan.

Dans ce mode de réalisation particulier, le contact 14 peut également traverser le motif 5 pour connecter une autre portion du substrat de support.

Ce mode de réalisation particulier permet, par exemple, de polariser deux contre-électrodes 4 adjacentes avec le même potentiel bien que les deux contre-électrodes 4 soient physiquement distinctes.

Le contact 14 est disposé dans le motif d'isolation, de préférence au-dessus d'une première couche en matériau électriquement isolant de manière à réduire l'impact électrique de la polarisation de la contre-électrode 4 sur le substrat de support.

La connexion électrique entre la contre-électrode 4 et le contact 14 est réalisée au moyen de leurs faces latérales ce qui permet d'obtenir des surfaces de connexion importantes pour une bonne application de la polarisation. Comme la connexion est réalisée de manière latérale, la surface de contact est également fonction de l'épaisseur du contact, de l'épaisseur de la contre-électrode et de leur surface de recouvrement. Cette architecture permet également de limiter les contraintes sur la profondeur d'enfoncement du motif d'isolation dans le substrat de support car le contact 14 est formé à travers le motif et non plus sous le motif comme dans l'art antérieur.

Dans un mode de réalisation préférentiel, le contact 14 est formé dans un matériau différent de celui formant la contre-électrode 4 et avec une conductivité supérieure à celui formant la contre-électrode 4.

Dans un mode de réalisation particulier illustré à la figure 4, deux transistors sont intégrés sur le substrat et sont associés chacun à une contre-électrode. Les deux contre-électrodes 4a et 4b sont formées par dopage du substrat de support avec des propriétés électriques différentes. A titre d'exemple, les niveaux de dopages sont différents, les impuretés dopantes sont différentes, les types de dopages sont différents et/ou les épaisseurs des contre-électrodes 4a et 4b sont différentes.

Chaque contre-électrode 4 est associée à un contact 14 qui traverse le motif d'isolation 5 pour ressortir sur sa face supérieure. Cependant, dans ce mode de réalisation particulier le contact 14 est, par exemple, relié électriquement aux portions adjacentes du substrat de support 1.

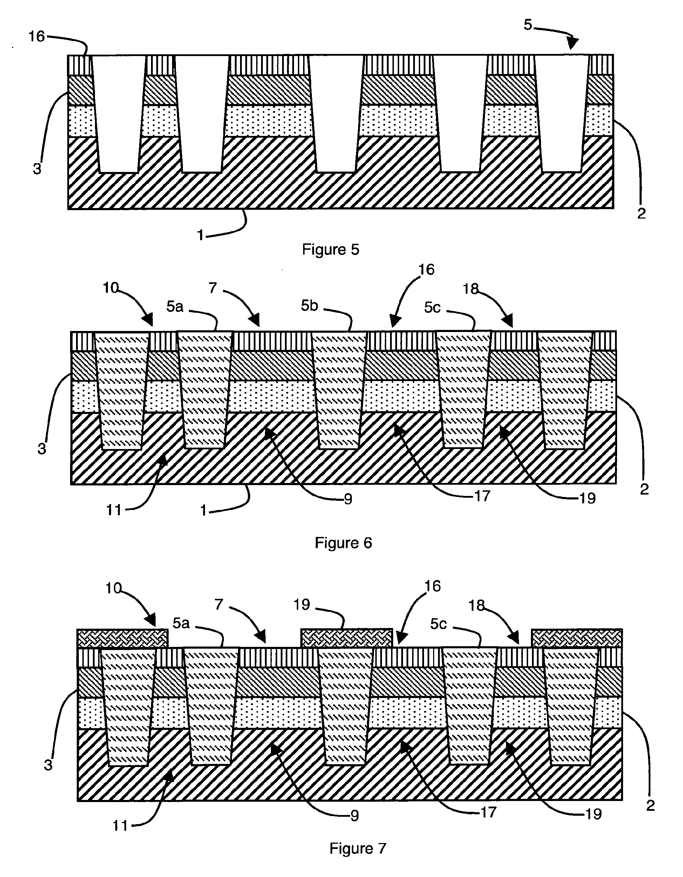

Le transistor peut être formé par un procédé de fabrication illustré aux figures 5 à 12.

Comme cela est illustré à la figure 5, en coupe, la face principale du substrat est recouverte par un masque de gravure 16. Le substrat est gravé à travers le masque de gravure 16 jusqu'à atteindre une profondeur prédéterminée du substrat de support 1. Le masque de gravure 16 définit simultanément les zones actives, les différentes portions du substrat de support 1 et le motif d'isolation 5. Dans l'exemple illustré, le motif d'isolation 5 correspond à la partie gravée du substrat, à cet instant c'est une zone vide.

Pour réaliser une gravure aisée du substrat, le masque de gravure 16 est, par exemple, un matériau diélectrique. De manière plus particulière, le matériau du masque de gravure 16 peut être un oxyde de silicium, un nitrure de silicium ou un empilement de ces derniers.

Un premier matériau électriquement isolant est déposé de manière à remplir les espaces vides formés suite à la gravure du substrat. Le motif d'isolation 5 est alors formé par le premier matériau électriquement isolant qui est, par exemple, un oxyde de silicium. Le masque de gravure 16 est réalisé par toute technique adaptée.

Comme cela est illustré à la figure 5, à titre d'exemple, le substrat comporte des première, deuxième, troisième et quatrième zones actives et portions du substrat de support 1. Les zones actives sont décalées latéralement les unes par rapport aux autres. Les portions du substrat de support 1 sont également décalées latéralement les unes par rapport aux autres. La première zone active 7 fait face à la première portion 9. La deuxième zone active 10 fait face à la deuxième portion 11. La troisième zone active 16 fait face à la troisième portion 17. La quatrième zone active 18 fait face à la quatrième portion 19. La forme des zones actives est quelconque. La disposition des différentes zones actives les unes par rapport aux autres est également quelconque.

Comme cela est illustré à la figure 6, bien que le motif d'isolation 5 entoure toutes les zones actives et les portions du substrat de support, pour des raisons de clarté, le motif d'isolation est décomposé en plusieurs motifs d'isolation élémentaires. Un premier motif d'isolation 5a est disposé entre les première et deuxième zones actives 7 et 10. Un deuxième motif d'isolation 5b est disposé entre les première et troisième zones actives 7 et 16. Un troisième motif d'isolation 5c est disposé entre les troisième et quatrième zones actives 16 et 18.

Si le premier matériau électriquement isolant est déposé sur tout le substrat, une étape de gravure et/ou de polissage mécano-chimique permet de localiser le premier matériau électriquement isolant uniquement dans les trous formés dans le substrat.

De manière préférentielle et comme cela est illustré à la figure 7, un second masque de gravure 19 peut être utilisé afin de limiter la partie du motif d'isolation 5 qui est à éliminer. Ainsi, il est possible de graver toute la surface du motif d'isolation 5 ou de limiter l'étendue de la gravure du motif autour de des zones actives. Il est encore possible de préciser que le motif doit être conservé d'un côté du transistor alors qu'il doit être éliminé de l'autre côté du transistor.

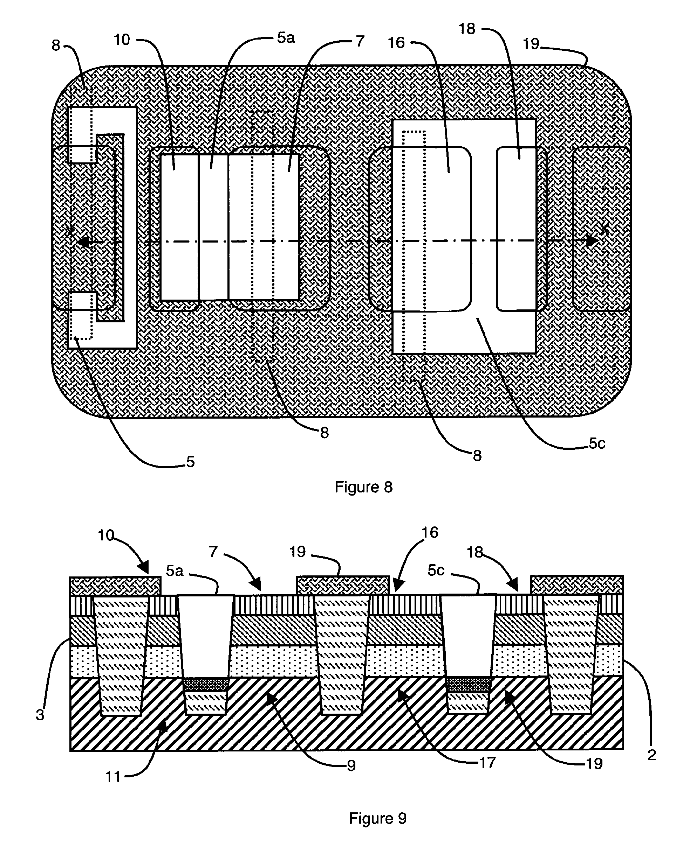

Comme cela est illustré à la figure 8 en vue de dessus, le second masque de gravure 19 autorise une grande souplesse dans la définition du contact et dans son étendu à l'intérieur du motif d'isolation 5. Comme cela est illustré à la figure 8, à titre d'exemple, le second masque de gravure 19 peut limiter le contact 14 à une face latérale de la zone active 7 (partie centrale de la figure 8) ou imposer un contact 14 sur plusieurs faces latérales de la zone active 16 (trois faces latérales successives dans la partie droite de la figure 8). Il est également envisageable d'avoir un contact sur toutes les faces latérales et donc de former un anneau de polarisation autour de la portion associée du substrat de support. Il est également envisageable de former un contact sur deux faces opposées de la portion du substrat de support (partie gauche de la figure 8).

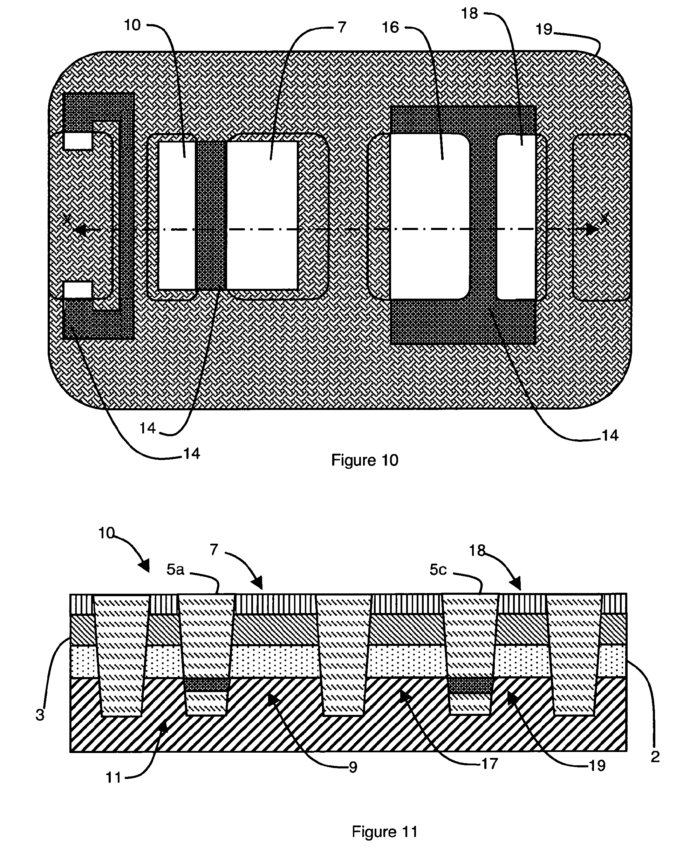

Comme cela est illustré aux figures 9 et 10, le motif d'isolation 5 est gravé de manière à atteindre le film électriquement conducteur du substrat de support. De cette manière, au moins une partie latérale du film est rendu libre. De manière préférentielle, le masque de gravure 16 est conservé durant l'élimination partielle du premier matériau électriquement isolant afin de protéger la face principale du film 3. La profondeur d'enfoncement de la gravure dans le motif d'isolation 5 permet de définir la position du contact 14 par rapport à la contre-électrode 4.

De manière avantageuse, la gravure du motif d'isolation 5 est réalisée de manière anisotrope en utilisant le second masque de gravure 19, mais il est également possible de réaliser une gravure isotrope avec ou sans second masque de gravure.

Une fois que la contre-électrode 4 ou que la zone servant à former la contre-électrode est accessible, un film électriquement conducteur est déposé sur le premier matériau électriquement isolant dans le motif d'isolation 5 de manière à être en contact électrique avec la contre-électrode 4. Le film électriquement conducteur permet de décaler la prise de contact de la contre-électrode 4 hors de la surface définie par la zone active. La prise de contact peut alors être réalisée dans le motif d'isolation 5 ou hors du motif d'isolation 5, par exemple dans la seconde portion 11.

Si le film électriquement conducteur formant le contact 14 est déposé dans des conditions telles qu'il est présent sur tout le substrat et qu'il rebouche complètement le motif d'isolation 5, il est possible de réaliser une localisation du film électriquement conducteur au moyen d'une étape de polissage mécano-chimique et/ou d'une étape de gravure plasma. De préférence, l'épaisseur du film électriquement conducteur déposé dans le motif 5 est choisie de manière à connecter électriquement la plus grande partie de la contre-électrode 4. Ainsi, l'épaisseur du film électriquement conducteur est choisie de manière à atteindre la couche électriquement isolante 2.

De manière préférentielle, le polissage mécano-chimique permet de localiser rapidement et facilement le matériau électriquement conducteur dans le volume restant du motif d'isolation 5. De manière encore plus préférentielle, le masque de gravure 16 est utilisé pour définir l'arrêt de l'étape de polissage mécano-chimique.

De manière intéressante, une étape de gravure humide ou par plasma permet de réduire l'épaisseur du film électriquement conducteur dans le motif d'isolation 5 de manière à ce que ce dernier soit localisé sous le niveau de l'interface entre la couche électriquement isolante 2 et le film 3 en matériau semi-conducteur. Cette précaution permet d'éviter tout court-circuit entre une électrode de source/drain du futur transistor et la contre-électrode 4. Ce mode de mise en oeuvre laisse une certaine souplesse dans les conditions d'intégration du contact 14. Il est possible d'avoir un contact 14 assez épais afin de limiter les problèmes de résistance série.

De manière encore plus avantageuse, le film électriquement conducteur formant le contact 14 est disposé sous le plan défini par l'interface entre le substrat de support 1 et la couche électriquement isolante 2. De cette manière l'effet électrostatique du contact 14 sur les électrodes 6 de source/drain est réduit ce qui permet de limiter les effets parasites sur la vitesse de commutation du transistor.

Le contact 14 électriquement conducteur comporte une couche électriquement conductrice ayant une surface principale parallèle à l'interface entre le substrat de support 1 et la couche électriquement isolante 2. De manière préférentielle, la couche électriquement conductrice est disposée dans le prolongement de la contre-électrode 4 sous la couche électriquement isolante 2.

Cependant, selon un autre point de vue, il peut être avantageux de garder une épaisseur suffisante du film électriquement conducteur afin d'avoir un contact électrique entre une électrode de source/drain du transistor et la contre-électrode.

De cette manière, selon les masques de gravure utilisés, il est possible d'avoir un film électriquement conducteur qui forme un anneau autour de la première portion 9 ce qui permet l'application d'un potentiel constant si le film électriquement conducteur est peu résistif. Le contact 14 peut comporter une zone en saillie dans une direction s'éloignant de la portion 9 contenant la contre-électrode 4 ce qui facilite la prise de contact dans une zone ayant une plus faible densité de contact. Il est également possible de limiter la position du film électriquement conducteur à une partie du transistor, par exemple du côté de la source ou du côté du drain afin de limiter le couplage électrostatique ou pour profiter d'un contact commun entre ces deux électrodes.

Dans un mode de réalisation privilégié, le film électriquement conducteur est un matériau métallique. Par exemple, le film électriquement conducteur est du TiN qui peut être gravé par voie humide au moyen d'une solution de N₃OH, H₂O₂ et H₂O de type « SC1 » ou au moyen d'une solution de HCI, H₂O₂, H₂O de type « SC2 ». Le film électriquement conducteur peut être du tungstène (W) qui peut être gravé par voie humide au moyen d'une solution de HF diluée avec HCI.

Le film électriquement conducteur peut également être un film semi-conducteur dopé, par exemple du silicium dopé qui peut être gravé par plasma avec une chimie à base de HBr.

Dans un mode de réalisation préférentiel illustré à la figure 11, le motif d'isolation 5 est de nouveau rempli par un second matériau électriquement isolant afin de faciliter le procédé de fabrication du transistor à venir. Le second matériau électriquement isolant peut être identique au premier matériau électriquement isolant ou différent. La localisation du second matériau électriquement isolant dans le motif d'isolation 5 est réalisée de la même manière que le premier matériau électriquement isolant.

Le masque de gravure 16 qui protégeait la face principale de la première zone active 7 est éliminé et un transistor est formé. Le substrat est recouvert par un matériau électriquement isolant et des trous sont formés dans ce matériau pour atteindre l'électrode de grille 8, les électrodes 6 de source et de drain et pour entrer en contact électrique avec le contact 14 hors de la première zone active 7. Le via 13 et d'autres via conducteurs sont, par exemple, formés à cette étape.

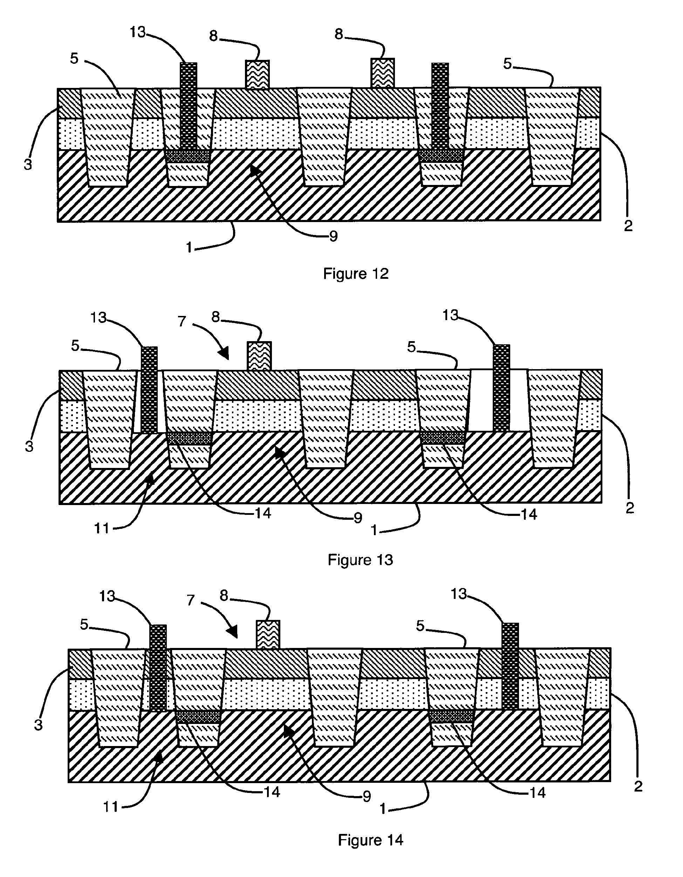

Dans un premier mode de réalisation illustré à la figure 12, un trou est formé dans le motif d'isolation 5 et un via 13 électriquement conducteur s'enfonce dans le motif d'isolation 5 jusqu'à atteindre le contact 14. De cette manière, il n'est pas nécessaire d'utiliser une seconde zone active et une seconde portion du substrat de support 1 pour assurer la polarisation de la contre-électrode 4. La seconde face du motif d'isolation 5 qui sert à la traversée du contact 14 est une face principale du motif 5 qui est parallèle à une face principale de la couche en matériau semi-conducteur 3.

Dans un second mode de réalisation illustré à la figure 13, le contact 14 traverse le motif d'isolation 5 depuis une première face latérale vers une seconde face latérale du motif d'isolation 5. La première face est une face latérale du motif d'isolation 5 qui a une interface avec la première portion 9 du substrat de support 1 et avantageusement avec la première zone active 7. La seconde face est une autre face latérale du motif d'isolation, par exemple la face opposée, qui a une interface avec une seconde portion 11 du substrat de support 1 et avantageusement avec la seconde zone active 10. La seconde zone active est éliminée ainsi que la partie de la couche électriquement isolante 2 juste au-dessus de la seconde portion 11 du substrat de support 1. Le via électriquement conducteur 13 est réalisé directement sur le substrat de support 1 dans la seconde portion 11 pour polariser la contre-électrode 4.

Dans une autre variante de réalisation illustrée à la figure 14, le via 13 s'enfonce à travers la seconde zone active et à travers la couche électriquement isolante 2 de manière atteindre le substrat de support1. Ainsi, le potentiel appliqué sur le substrat de support 1 dans la seconde portion 11 est répercuté à la contre-électrode via le contact 14.

Ces trois modes de réalisation peuvent être combinés entre eux selon les cas de figures.

Dans un mode particulier de réalisation qui peut être combiné avec les modes de réalisation précédents, la contre-électrode 4 est face au canal du transistor uniquement, afin de limiter l'effet électrostatique sur les électrodes 6 de source et drain. Le film électriquement conducteur du contact 14 est formé à l'intérieur du motif d'isolation 5 qui entoure la zone active et la première portion du substrat de support. II est possible d'avoir accès à la contre-électrode 4 sous l'électrode de grille 8 sans passer par les zones faisant face aux électrodes 6 de source et de drain et sans être gêné par l'électrode de grille 8 comme cela est illustré en vue de dessus sur la partie gauche de la figure 10, les futures grilles étant représentées en pointillé.

Dans un autre mode de réalisation particulier qui peut être combiné avec les modes de réalisation précédents, la seconde portion 11 du substrat de support 1 comporte une couche électriquement conductrice qui provient de la réaction entre un métal et un matériau semi-conducteur formant le substrat de support, par exemple un siliciure comme un siliciure de nickel ou de titane. Ce matériau particulier permet de limiter la résistance électrique entre le via conducteur et la contre-électrode. Ce mode de réalisation est particulièrement facile à mettre en oeuvre dans le cas de la figure 13, par exemple lors de siliciuration des électrodes de source/drain et de grille avant de former les contacts/via.

Le film électriquement conducteur du contact 14 étant déposé durant la formation du motif d'isolation 5, il est possible de maîtriser la position du film électriquement conducteur par rapport à la position de la couche électriquement isolante 2. Il est également possible de maîtriser l'épaisseur déposée de film électriquement conducteur afin de limiter la résistance électrique depuis le via conducteur 13 et/ou de fixer l'influence électrique du film électriquement conducteur vis-à-vis du substrat et du reste du motif d'isolation 5.

Le film électriquement conducteur est, de préférence, déposé avant de former le transistor à effet de champ sur la première zone active.

Le second masque de gravure 19 permet de limiter l'étendue du film électriquement conducteur dans le motif d'isolation 5 et il permet également de réaliser de la co-intégration dans le circuit et/ou d'éviter un court-circuit entre deux contre-électrodes 4 associées à des potentiels différents.

A titre d'exemple illustré à la figure 4, deux zones actives adjacentes sont associées chacune à un transistor à effet de champ qui est intégré avec une contre-électrode. Les deux zones actives sont séparées latéralement par le motif d'isolation 5. Il en va de même des deux portions du substrat de support qui font respectivement face aux deux zones actives.

La première contre-électrode 4a est reliée à des premiers moyens de polarisation suivant une première tension de polarisation alors que la deuxième contre-électrode 4b est associée à des deuxièmes moyens de polarisation suivant une deuxième tension de polarisation. Les polarisations étant appliquées à travers le motif d'isolation 5 et non plus en passant sous le motif d'isolation, il est possible d'appliquer une plus grande gamme de polarisation sans risquer d'éventuels courts-circuits.

Dans un mode de réalisation particulier non représenté, lors de la localisation du premier matériau électriquement isolant dans le motif d'isolation 5, le motif d'isolation comporte une partie inférieure en premier matériau électriquement isolant et une zone vide au-dessus. Le matériau électriquement conducteur est ensuite déposé puis gravé afin délimiter les futurs contacts 14. La forme des contact est par exemple réalisée à partir d'un masque qui a une polarité opposée au second masque 19.

Le matériau formant le contact 14 peut être déposé par toute technique adaptée de manière plus ou moins conforme. Dans le cas d'un dépôt conforme, il est préférable de remplir complètement le volume vide du motif d'isolation puis d'aplanir et éliminer le matériau électriquement conducteur pour avoir un contact 14 avec l'épaisseur voulue.

Dans le cas d'un dépôt moins conforme avec une croissance privilégiée dans le fond du motif d'isolation 5 par rapport au dépôt sur les parois latérales, il est préférable d'alterner les étapes de dépôt et gravure afin de former des couches successives de matériau conducteur jusqu'à atteindre l'épaisseur désirée.

## Revendications

1. Transistor à effet de champ comportant :
- un substrat comprenant successivement un substrat de support (1) électriquement conducteur, une couche électriquement isolante (2) et une couche en matériau semi-conducteur (3),
- une contre-électrode (4) formée dans une première portion (11) du substrat de support (1) face à la couche en matériau semi-conducteur (3),
- un motif d'isolation (5) en matériau électriquement isolant entourant la couche en matériau semi-conducteur (3) pour délimiter une première zone active (7) en matériau semi-conducteur et s'enfonçant partiellement dans la couche de support (1) pour délimiter la première portion (11),
transistor **caractérisé en ce qu'**il comporte
- un contact (14) électriquement conducteur traversant le motif d'isolation (5) depuis une première face latérale en contact avec la contre-électrode (4) jusqu'à une seconde face, le contact (14) étant connecté électriquement à la contre-électrode (4).

2. Transistor selon la revendication 1, **caractérisé en ce que** le contact (14) électriquement conducteur comporte une couche électriquement conductrice ayant une surface principale parallèle à l'interface entre le substrat de support (1) et la couche électriquement isolante (2).

3. Transistor selon la revendication 2, **caractérisé en ce que** la couche électriquement conductrice est disposée dans le prolongement de la contre-électrode (4) sous la couche électriquement isolante (2).

4. Transistor selon l'une quelconque des revendications 1 à 3, **caractérisé en ce que** la seconde face du motif d'isolation (5) est une face principale parallèle à une face principale de la couche en matériau semi-conducteur (3).

5. Transistor selon l'une quelconque des revendications 1 à 3, **caractérisé en ce que** la seconde face du motif d'isolation (5) est une face latérale ayant une interface avec une seconde portion (10) de la couche de support (1) délimitée par le motif d'isolation (5).

6. Procédé de fabrication d'un transistor à effet de champ comportant :
- prévoir un substrat comportant successivement une couche de support (1), une couche électriquement isolante (2), une couche en matériau semi-conducteur (3), un motif d'isolation (5) délimitant une première zone active (7) dans la couche en matériau semi-conducteur (3) et une première portion (9) dans la couche de support (1), la première zone active (7) et la première portion (9) se faisant face,
- graver partiellement le motif d'isolation (5) pour accéder à la première portion (9) de la couche de support (1),
- déposer un film électriquement conducteur en contact de la première portion (9) de la couche de support (1), sur le motif d'isolation (5).

7. Procédé selon la revendication 6 **caractérisé en ce qu'**il comporte : déposer un film électriquement isolant sur le film électriquement conducteur.

8. Procédé selon la revendication 7 **caractérisé en ce qu'**il comporte graver partiellement le film électriquement isolant et former un via (13) électriquement conducteur connectant le film électriquement conducteur.

9. Procédé selon l'un quelconque des revendications 6 à 8, **caractérisé en ce que** le substrat comporte une seconde portion formée dans la couche de support (1) et délimitée par le motif d'isolation (5) et **en ce que** le film électriquement conducteur (3) est déposé de manière à connecter électriquement la première portion (9) avec la seconde portion (11).
